# EUROPEAN PATENT APPLICATION

(11) **EP 3 242 383 A1**
(43) Date of publication of application: **08.11.2017**
(21) Application number: 16167998.0
(22) Date of filing: 03.05.2016
(51) Int. Cl.: H02M 1/12, G01R 31/42, G01R 27/26, G01R 31/28, H02M 7/48

(54) **METHOD FOR MONITORING CHANGE IN CAPACITANCE OF AC FILTER IN ELECTRIC SYSTEM AND ELECTRIC SYSTEM**

(71) Applicant: ABB Technology Oy, 00380 Helsinki (FI)
(72) Inventor: Viitanen, Tero, 00380 Helsinki (FI); Alahuhtala, Jarno, 00380 Helsinki (FI); Heikkilä, Teemu, 00380 Helsinki (FI); Routimo, Mikko, 00380 Helsinki (FI)
(74) Representative: Kolster Oy Ab

(57) **Abstract**

A method for monitoring a change in a capacitance of an AC filter in an electric system, and an electric system comprising a converter (10), an AC filter (20) comprising at least one capacitance and being connected to the AC output of the converter, switching means (K) connected to an output of the AC filter, and control means (11) configured to control the switching means to open circuit the output of the AC filter, supply by the converter (10) an AC voltage with a predetermined magnitude and a predetermined frequency from the AC output of the converter to the AC filter, monitor a current or currents flowing through the AC output of the converter as a result of the AC voltage supplied to the AC filter, and determine on the basis of the monitored current or currents a change in the at least one capacitance of the AC filter.

## Description

### Field of the invention

The invention relates to a method for monitoring a change in a capacitance of an AC filter in an electric system, and to an electric system.

### Background of the invention

Various converters able to produce an AC voltage from their AC outputs include AC-AC converters, such as indirect AC-AC converters or direct AC-AC converters, and DC-AC converters, i.e. inverters. An inverter, for example, is an electrical device enabling conversion of DC (direct current) power from a DC power source to AC (alternating current) power. Herein the term 'inverter' generally refers to an electronic device or circuitry that is able to convert direct current to alternating current. An example of the inverter is a semiconductor bridge implemented by means of controllable semiconductor switches, such as IGBTs (Insulated-gate Bipolar Transistor) or FETs (Field-Effect Transistor), which are controlled according to a modulation or control scheme used.

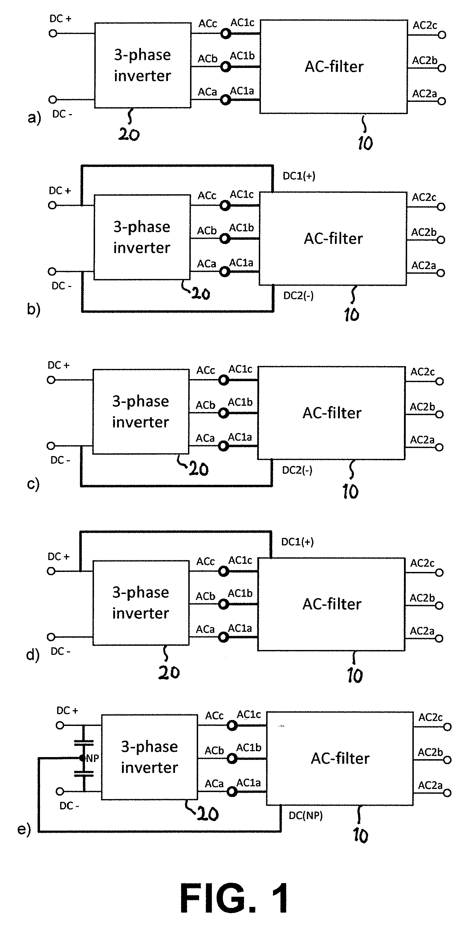

An AC output filter connected to an AC output of a converter may be provided in order to filter the AC output of the converter in a desired manner. Examples of such AC filters include an LC filter, an LCL filter and an RCL filter which comprise at least one capacitance and at least one inductance, typically at least one capacitance per phase and at least one inductance per phase, depending on the configuration of the filter. Figure 1 shows examples of an AC filter 10 connected to the AC output of an inverter 20, wherein the AC input terminals AC1a, AC1b, AC1c of the AC filter 10 are connected to the AC output terminals ACa, ACb, ACc of the inverter 20. Example a) comprises only AC phase connections between the AC filter 10 and the inverter 20 while examples b), c), d) and e) further comprise at least one DC circuit connection DC1(+), DC2(-), DC(NP) between the AC filter 10 and the inverter 20.

The capacitance of the AC output filter of the inverter is a quantity significant to the operation of the inverter as it affects the control dynamics of the inverter and also provides a high-frequency current path for the PWM current from the inverter, thus reducing the PWM current injected to the AC system.

The capacitance of the AC filter may start to decrease over time. For example, a common type of capacitor used in AC filters is a film capacitor, in which the capacitance thereof tends to decrease over time as a result of the capacitor self-healing process. In the self-healing process a conductor metallized on the surface of an insulating film vaporizes as a result of partial discharges through the insulation. The self-healing process produces detrimental hydrogen gases which may cause a danger of explosion upon build-up thereof. The capacitance of the AC filter may also decrease as a result of corona, which may be emphasized by moisture being absorbed to the insulation of the capacitor.

A problem related to the possible decrease of the capacitance of the AC filter over time is that if it is not monitored, then the control dynamics of the converter may suffer over time and there may also be a risk of explosion. The capacitance of the AC filter could be monitored by manually measuring the capacitance periodically. Such a solution would be burdensome and costly in practice.

### Brief description of the invention

An object of the invention is to provide a method and an apparatus for implementing the method so as to solve or at least alleviate the above problems. The object of the invention is achieved by a method, a computer program product, and an electric system that are characterised by what is stated in the independent claims. Preferred embodiments of the invention are described in the dependent claims.

The invention is based on the idea of supplying by a converter an AC voltage with a predetermined magnitude and a predetermined frequency to the AC filter while the output of the AC filter is open-circuited, monitoring a current flowing through the AC output of the converter as a result of the AC voltage supplied to the AC filter, and determining, on the basis of the monitored current, a change in at least one capacitance of the AC filter.

The solution of the invention provides the advantage that the capacitance of the AC filter can be easily monitored. In addition, the invention can be implemented by using existing system elements and hence any additional measuring devices are not necessarily needed.

### Brief description of the figures

The invention will now be explained in greater detail in connection with preferred embodiments and with reference to the attached drawings, in which:
Figure 1 shows examples of connecting an AC filter to an inverter;
Figure 2 shows an example of an electric system according to an embodiment;
Figure 3 shows an example of an AC filter according to an embodiment;
Figure 4 shows an impedance diagram of an AC filter according to an embodiment; and
Figure 5 shows an impedance diagram of an AC filter according to an embodiment.

### Detailed description of the invention

The application of the invention is not restricted to any specific system, but it may be applied to various electric systems comprising a converter with an AC output and an AC filter. The converter may be an AC-AC converter, such as an indirect AC-AC converter or a direct AC-AC converter. The converter may also be a DC-AC converter, i.e. an inverter. In addition, the use of the invention is not restricted to any specific basic frequency of the system or to any specific voltage level.

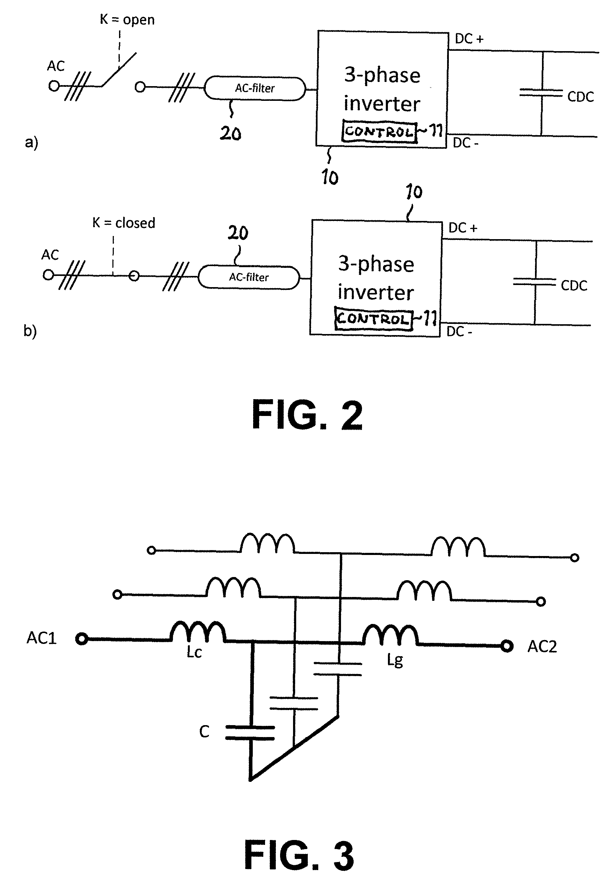

Figure 2 shows an example of a main circuit of an electric system according to an embodiment. The number of various components may vary from that shown in the figure. The exemplary electric system comprises a converter, in this example an inverter 10 having a DC input DC+, DC-, which may be connected to a suitable DC supply CDC, and an AC output. In place of the exemplary inverter 10 there could be another type of converter with an AC output. Thus, any of the following exemplary embodiments could be implemented with such another type of converter with an AC output instead of the inverter 10. The inverter 10 can have one phase, three phases or more than three phases. The exemplary electric system comprises an AC filter 20, wherein an input of the AC filter is connected to the AC output of the inverter 10. The number of phases of the AC filter 20 preferably corresponds to that of the inverter 10. The connection of the AC filter 20 to the inverter 10 could be performed according to any one of the examples a) to e) of Figure 1, for example. The exemplary electric system further comprises switching means K connected to the output of the AC filter 20. In example a) the switching means K are illustrated as open, i.e. non-conductive, and in example b) the switching means K are illustrated as closed, i.e. conducting. The switching means K can consist of or comprise any kind of switch device, such as a mechanical switch or a semiconductor switch, with which the AC side of the electric system can be connected to and disconnected from any other AC systems AC, such as AC networks or AC loads. Consequently, the switching means K enable the output of the AC filter 20 to be open-circuited when desired. Figure 2 further shows a control arrangement 11 of the inverter 10 which can control the operation of the inverter 10. The control arrangement 11 can preferably also control the switching means K. The control arrangement 11 may further perform measurements of or receive input signals regarding various quantities, such as current or voltage quantities, in order to perform the control of the inverter 10, for example. Possible measuring arrangements for such quantities are not shown in the figure for the sake of clarity. The control arrangement 11 of the inverter 10 can be used for implementing the functionality according to the various embodiments described herein. Alternatively it would be possible to use a control arrangement separate from the inverter 10. For example, it would be possible to use additional or separate logical or physical units (not shown) for performing the control functionality of the various embodiments. The functionality of the various embodiments could, for example, be implemented using a separate logic arrangement, which could be at least partly independent of the normal control of the inverter 10, for example.

According to an embodiment, the AC filter 20 comprises at least one capacitance and at least one inductance. Such an AC filter could be or at least comprise an LC filter or an LCL filter or any derivatives thereof, for example. Figure 3 shows an example of a three-phase LCL filter which comprises one capacitance C and two inductances Lc, Lg between the AC input AC1 and the AC output AC2 for each of the three phases. Each of the capacitances C can comprise one or more capacitors and each of the inductances Lc, Lg can comprise one or more inductors. In the example of Figure 3 the capacitances C are star-connected but they could alternatively be delta-connected, for example. Moreover, the AC filter 20 could comprise one or more resistances, for example. Thus, it should be noted that the configuration of the AC filter 20 may vary.

According to an embodiment, the monitoring of a change in a capacitance of the AC filter 20 in the electric system comprises first controlling the switching means K connected to the output of the AC filter 20 to open circuit the output of the AC filter. In other words, in the example of Figure 2 the switching means K are controlled to be open corresponding to example a) of Figure 2, whereby the output of the AC filter 20 becomes open-circuited, i.e. the terminals of the output of the AC filter 20 are not electrically connected to each other, e.g. directly or via any other components or systems, such as load or AC network. Then, while the output of the AC filter 20 is open-circuited, an AC voltage with a predetermined magnitude and a predetermined frequency is supplied by the inverter 10 from the AC output of the inverter to the AC filter 20. This may be implemented by suitably modulating the inverter 10. Then, a current or currents flowing through the AC output of the inverter 10 as a result of the AC voltage supplied to the AC filter is/are monitored. Finally, a change in the at least one capacitance of the AC filter 20 is determined on the basis of the monitored current or currents.

When the AC output of the AC filter is open-circuited and consequently no current flows through the AC output of the AC filter 20, the current path or paths for current or currents flowing through the AC output of the inverter 10 as a result of the AC voltage supplied to the AC filter is/are closed through the at least one capacitance of the AC filter 20, and hence the possible change in said at least one capacitance can be determined on the basis of such a current as the value of the capacitance affects the value of the current. Such determination of the change in the at least one capacitance of the AC filter 20 may be based on an absolute value of the at least one capacitance or on a quantity or a factor proportional to the at least one capacitance of the AC filter 20, for example. An example of a quantity proportional to the at least one capacitance of the AC filter 20 is the current or currents flowing through the AC output of the inverter 10 as a result of the AC voltage supplied to the AC filter, as explained above.

According to an embodiment, the determination of the change in the at least one capacitance of the AC filter 20 on the basis of the monitored current or currents may comprise comparing the value of the monitored current or currents to a current reference value, and then determining the change in the at least one capacitance of the AC filter on the basis of a difference between the value of the monitored current or currents and the current reference value. In the case of systems having more than one phase, the current of one or more phases could be used in the comparison. Moreover, such a current reference value could be a predetermined current value or a current value obtained in some previous measurement, for example. When the change in the at least one capacitance of the AC filter is determined on the basis of the difference between the value of the monitored current or currents, it may be preferable that the product of the frequency and the magnitude of the AC voltage supplied to the AC filter remains the same, which makes such comparisons more straightforward.

According to an embodiment, the determination of the change in the at least one capacitance of the AC filter 20 on the basis of the monitored current or currents may comprise determining a value of the at least one capacitance of the AC filter, or a quantity indicative thereof, on the basis of the value of the monitored current or currents and the predetermined frequency and magnitude of the AC voltage, comparing the determined value of the at least one capacitance of the AC filter, or the quantity indicative thereof, to a capacitance reference value, and determining the change in the at least one capacitance of the AC filter on the basis of a difference between the determined value of the at least one capacitance of the AC filter, or the quantity indicative thereof, and the capacitance reference value. In other words, it is possible to calculate the value of the at least one capacitance of the AC filter, or a quantity indicative thereof, at least with a reasonable accuracy on the basis of the value of the monitored current or currents and the predetermined frequency and magnitude of the AC voltage. Then, such a calculated value may be used to determine the change in the at least one capacitance of the AC filter. Again, in the case of systems having more than one phase, the current of one or more phases could be utilized. Moreover, such a capacitance reference value could be a nominal value of the capacitance in question or a previously measured value for the capacitance, for example.

According to an embodiment, the determination of the change in the at least one capacitance of the AC filter 20 on the basis of the monitored current or currents may comprise, when the inverter 10 and the AC filter 20 have at least three phases, comparing the value of the monitored current of each phase to the monitored current of one or more other phases, and determining the change in the at least one capacitance of the AC filter on the basis of a difference between the values of the monitored currents of the different phases. Accordingly, it is possible to compare values of different phases to each other, either alternatively or additionally to comparing them to reference values, in order to determine the change in the at least one capacitance of the AC filter 20. In the case of a multi-phase AC filter the phases are typically symmetric and hence, if the comparison of phase-specific values shows asymmetry, this may indicate a change in one or more of the capacitances. However, the tolerances of the component values may need to be taken into account.

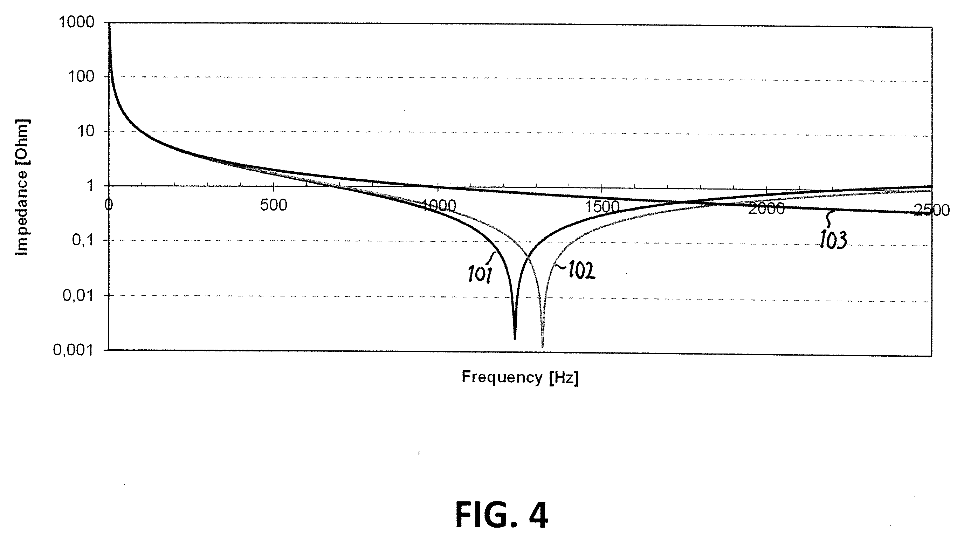

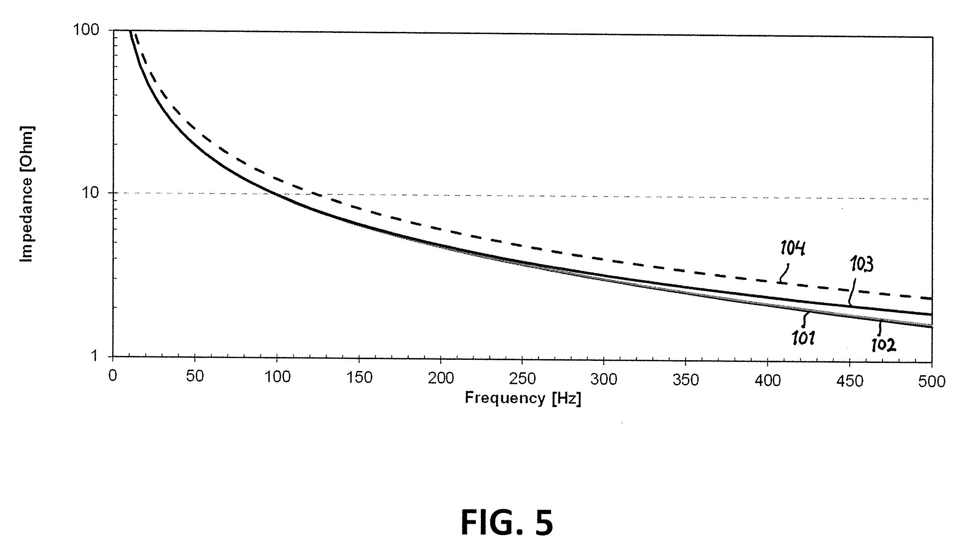

According to an embodiment, the predetermined frequency of the AC voltage supplied by the inverter 10 from the AC output of the inverter to the AC filter 20 is preferably lower than an expected resonance frequency of the AC filter 20 when the output of the AC filter is open-circuited. The term expected resonance frequency herein generally refers to a nominal value of said resonance frequency, which may be known or calculated based on known component values of the AC filter in question, or to a previously measured value of said resonance frequency. According to an embodiment, the predetermined frequency of the AC voltage is lower than 50% of the expected resonance frequency of the AC filter when the output of the AC filter is open-circuited. Figure 4 shows an exemplary impedance diagram of an AC filter according to an embodiment. The exemplary AC filter is an LCL filter corresponding to that of Figure 3. The impedance diagram shows the impedances of the different branches of the AC filter as a function of the frequency, i.e. the impedance curve 101 of impedance |Z(LcC)| and the impedance curve 102 of impedance |Z(LgC)|. In addition the impedance curve 103 of impendance |1/wC| is shown, i.e. the impedance of the capacitance C alone. In the example the resonance frequency of the AC filter 20, when the output of the AC filter is open-circuited, is determined by impedance |Z(LcC)|. As can be seen from the corresponding impedance curve 101, the resonance frequency is approximately 1240 Hz. Figure 5 shows an impedance diagram corresponding to that of Figure 4 but with a narrower frequency range. Figure 5 further illustrates impedance curve 104 of impedance |1/wC*| which represents the capacitance C when reduced to 80% of its original value. As can be seen from the figures, at lower frequencies (below ∼500 Hz in the Figures) the series impedance formed by the inductance and the capacitance is almost completely determined by the impedance of the capacitance C (= 1/(2πfC), where f is the frequency). Also, when the impedance value in this exemplary case is over 1 ohm, resistances of possible stray quantities do not have any significant distorting effect as they are typically significantly lower than 1 ohm. Also, even if the circuit had ohmic losses, they typically remain constant and can therefore be ignored. The predetermined frequency of the AC voltage supplied by the inverter 10 from the AC output of the inverter to the AC filter 20 is preferably lower, or significantly lower, than 50% of the expected resonance frequency of the AC filter because then the accuracy of the impedance determination can be improved, as can be seen from the exemplary diagrams.

According to an embodiment, the predetermined magnitude (amplitude) of the AC voltage supplied by the inverter 10 from the AC output of the inverter to the AC filter 20 is preferably selected between zero and a nominal value for the AC output voltage of the inverter, for example. In practice it may be advantageous to use relatively high magnitude in order to cause a current high enough to be reliably measured.

According to an embodiment, the AC voltage supplied by the inverter 10 from the AC output of the inverter to the AC filter 20 may comprise only a differential mode voltage component or both a differential mode voltage component and a common mode voltage component. The possible components of the AC voltage can be used to examine the possible branches of the AC filter which may comprise e.g. star-connected or delta-connected capacitances. The differential mode voltage component may be used to determine capacitances between the phases. The common mode voltage component may be used to determine phase quantities particularly in a situation in which each phase of the AC filter forms a closed current path via which a common mode current can flow. This is the case when the capacitances are star-connected and the star point is connected to the intermediate circuit of the inverter, for example. The AC voltage supplied by the inverter 10 from the AC output of the inverter to the AC filter 20 is preferably modulated with a PWM frequency higher than the expected resonance frequency of the AC filter while the frequency of the AC voltage is preferably lower than an expected resonance frequency of the AC filter, as explained already above.

The result of the determination of the change in the at least one capacitance of the AC filter 20 according to any of the embodiments described herein may be used in several ways. It may be used to update a corresponding parameter or parameters used in the inverter control, for example. Alternatively or additionally, it may be used to monitor the condition of the at least one capacitance. For example, if the determined change in the at least one capacitance of the AC filter 20 is higher than a predetermined threshold, it may be concluded that the condition of the at least one capacitance has changed significantly. Then it is possible to create a notification or an alarm to a user of the system and/or trigger automatic safety procedures, such as stopping the inverter, for example.

The determination of the change in the at least one capacitance of the AC filter 20 according to any of the embodiments described herein may be performed at predetermined intervals and/or upon a certain event, such as starting the inverter 10, for example. Since the current or currents flowing through the AC output of the inverter 10 as a result of the AC voltage supplied to the AC filter 20, when the output of the AC filter is open-circuited, is mainly reactive current, it does not transfer real power and hence does not significantly affect the voltage of the DC circuit connected to the inverter 10. As a result, it is possible to perform the determination of the change in the at least one capacitance of the AC filter 20 in connection with charging of the capacitance CDC of such a DC circuit connected to the inverter 10, for example, such that the determination is performed after the charging, and only after that is the inverter 10 connected to other AC systems AC, such as AC networks or AC loads.

The control arrangement 11 and/or a possible separate control arrangement can be implemented as one unit or as two or more separate units that are configured to implement the functionality of the various embodiments described herein. Here the term 'unit' refers generally to a physical or logical entity, such as a physical device or a part thereof or a software routine. The control arrangement 11 according to any one of the embodiments may be implemented at least partly by means of one or more computers or corresponding digital signal processing (DSP) equipment provided with suitable software, for example. Such a computer or digital signal processing equipment preferably comprises at least a working memory (RAM) providing a storage area for arithmetical operations, and a central processing unit (CPU), such as a general-purpose digital signal processor. The CPU may comprise a set of registers, an arithmetic logic unit, and a CPU control unit. The CPU control unit is controlled by a sequence of program instructions transferred to the CPU from the RAM. The CPU control unit may contain a number of microinstructions for basic operations. The implementation of microinstructions may vary depending on the CPU design. The program instructions may be coded by a programming language, which may be a high-level programming language, such as C, Java, etc., or a low-level programming language, such as a machine language, or an assembler. The computer may also have an operating system which may provide system services to a computer program written with the program instructions. The computer or other apparatus implementing the invention, or a part thereof, may further comprise suitable input means for receiving measurement and/or control data, for example, and output means for outputting control data, for example. It is also possible to use analog circuits, programmable logic devices (PLD), or discrete electric components and devices for implementing the functionality according to any one of the embodiments. For example, the control arrangement 11 according to any one of the embodiments may be implemented at least partly by means of such analog circuits or programmable logic devices.

The invention can be implemented in existing system elements or by using separate dedicated elements or devices in a centralized or distributed manner. Present inverters or generally converter devices, for example, can comprise programmable logic devices, or processors and memory that can be utilized in the functions according to embodiments of the invention. Thus, all modifications and configurations required for implementing an embodiment e.g. in existing inverters may be performed as software routines, which may be implemented as added or updated software routines. If at least part of the functionality of the invention is implemented by software, such software can be provided as a computer program product comprising computer program code which, when run on a computer, causes the computer or a corresponding arrangement to perform the functionality according to the invention, as described above. Such a computer program code may be stored or generally embodied on a computer readable medium, such as a suitable memory, a flash memory or an optical memory, for example, from which it is loadable to the unit or units executing the program code. In addition, such a computer program code implementing the invention may be loaded to the unit or units executing the computer program code via a suitable data network, for example, and it may replace or update a possibly existing program code.

It is obvious to a person skilled in the art that, as technology advances, the basic idea of the invention may be implemented in various ways. The invention and its embodiments are thus not restricted to the above examples but may vary within the scope of the claims.

## Claims

1. A method for monitoring a change in a capacitance of an AC filter in an electric system, the electric system comprising a converter (10) having an AC output, an AC filter (20), wherein an input of the AC filter is connected to the AC output of the converter, and wherein the AC filter comprises at least one capacitance (C) and at least one inductance (Lc), and switching means (K) connected to an output of the AC filter, the method comprising:
a) controlling the switching means (K) connected to the output of the AC filter (20) to open circuit the output of the AC filter;
b) supplying, while the output of the AC (20) filter is open-circuited, by the converter (10) an AC voltage with a predetermined magnitude and a predetermined frequency from the AC output of the converter to the AC filter (20);
c) monitoring a current or currents flowing through the AC output of the converter (10) as a result of the AC voltage supplied to the AC filter (20); and
d) determining on the basis of the monitored current or currents a change in the at least one capacitance (C) of the AC filter (20).

2. A method according to claim 1, wherein step d) comprises:
comparing the value of the monitored current or currents to a current reference value; and
determining the change in the at least one capacitance (C) of the AC filter (20) on the basis of a difference between the value of the monitored current or currents and the current reference value.

3. A method according to claim 1, wherein step d) comprises:
determining a value of the at least one capacitance (C) of the AC filter (20), or a quantity indicative thereof, on the basis of the value of the monitored current or currents and the predetermined frequency and magnitude of the AC voltage;
comparing the determined value of the at least one capacitance (C) of the AC filter (20), or the quantity indicative thereof, to a capacitance reference value; and
determining the change in the at least one capacitance (C) of the AC filter (20) on the basis of a difference between the determined value of the at least one capacitance of the AC filter, or the quantity indicative thereof, and the capacitance reference value.

4. A method according to claim 1, 2 or 3, wherein the converter (10) and the AC filter (20) have at least three phases, and wherein step d) comprises:
comparing the value of the monitored current of each phase to the monitored current of one or more other phases; and
determining the change in the at least one capacitance (C) of the AC filter (20) on the basis of a difference between the values of the monitored currents of the different phases.

5. A method according to any one of claims 1 to 4, wherein the predetermined frequency of the AC voltage is lower than an expected resonance frequency of the AC filter (20) when the output of the AC filter is open-circuited.

6. A method according to claim 5, wherein the predetermined frequency of the AC voltage is lower than 50% of the expected resonance frequency of the AC filter (20) when the output of the AC filter is open-circuited.

7. A computer program product comprising computer program code, wherein execution of the program code on a computer causes the computer to carry out the steps of the method according to any one of claims 1 to 6.

8. An electric system comprising:
a converter (10) having an AC output;
an AC filter (20) comprising at least one capacitance (C) and at least one inductance (Lc), wherein an input of the AC filter is connected to the AC output of the converter (10);
switching means (K) connected to an output of the AC filter (20); and
control means (11) configured to:
control the switching means (K) connected to the output of the AC filter (20) to open circuit the output of the AC filter;
supply, while the output of the AC filter (20) is open-circuited, by the converter (10) an AC voltage with a predetermined magnitude and a predetermined frequency from the AC output of the converter to the AC filter (20);
monitor a current or currents flowing through the AC output of the converter (10) as a result of the AC voltage supplied to the AC filter (20); and
determine on the basis of the monitored current or currents a change in the at least one capacitance (C) of the AC filter (20).

9. An electric system according to claim 8, wherein the control means (11) are configured to, when performing the determination of the change in the at least one capacitance (C) of the AC filter (20):
compare the value of the monitored current or currents to a current reference value; and
determine the change in the at least one capacitance (C) of the AC filter (20) on the basis of a difference between the value of the monitored current or currents and the current reference value.

10. An electric system according to claim 8, wherein the control means (11) are configured to, when performing the determination of the change in the at least one capacitance (C) of the AC filter (20):
determine a value of the at least one capacitance (C) of the AC filter (20), or a quantity indicative thereof, on the basis of the value of the monitored current or currents and the predetermined frequency and magnitude of the AC voltage;
compare the determined value of the at least one capacitance (C) of the AC filter (20), or the quantity indicative thereof, to a capacitance reference value; and
determine the change in the at least one capacitance (C) of the AC filter (20) on the basis of a difference between the determined value of the at least one capacitance of the AC filter, or the quantity indicative thereof, and the capacitance reference value.

11. An electric system according to claim 8, 9 or 10, wherein the converter (10) and the AC filter (20) have at least three phases and the control means (11) are configured to, when performing the determination of the change in the at least one capacitance (C) of the AC filter (20):
compare the value of the monitored current of each phase to the monitored current of one or more other phases; and
determine the change in the at least one capacitance (C) of the AC filter (20) on the basis of a difference between the values of the monitored currents of the different phases.

12. An electric system according to any one of claims 8 to 11, wherein the predetermined frequency of the AC voltage is lower than an expected resonance frequency of the AC filter (20) when the output of the AC filter is open-circuited.

13. An electric system according to claim 12, wherein the predetermined frequency of the AC voltage is lower than 50% of the expected resonance frequency of the AC filter (20) when the output of the AC filter is open-circuited.

14. An electric system according to any one of claims 9 to 13, wherein the AC filter (20) is an LC filter or an LCL filter.

15. An electric system according to any one of claims 9 to 14, wherein both the converter (10) and the AC filter (20) have at least three phases and the AC filter comprises at least one capacitance (C) per phase.
